# EUROPEAN PATENT APPLICATION

(11) **EP 4 570 946 A2**
(43) Date of publication of application: **18.06.2025**
(21) Application number: 24209839.0
(22) Date of filing: 30.10.2024
(51) Int. Cl.: C23C 16/44, C30B 23/06, C30B 25/10

(54) **TWO-CHAMBER REACTOR FOR EPITAXIAL DEPOSITION OF SEMICONDUCTOR MATERIAL ON SUBSTRATES**

(30) Priority: 31.10.2023 IT 202300022830
(71) Applicant: LPE S.p.A., 20021 Baranzate (MI) (IT)
(72) Inventor: Meschia, Maurilio, Asti (IT); Corea, Francesco, Bollate (MI) (IT); Polli, Stefano, Baranzate (MI) (IT); Preti, Silvio Roberto Mario, Baranzate (MI) (IT)
(74) Representative: De Gregori, Antonella

(57) **Abstract**

The innovative reactor comprises: a first reaction chamber (100), a second reaction chamber (200), an induction heating system for the reaction chambers (100, 200), and a liquid flow cooling system for the reaction chambers (100, 200). According to some designs, the cooling system comprises a reservoir (450) that is designed to contain coolant and that is divided into a first reservoir section (452) and a second reservoir section (454) in fluidic communication with each other. The two reaction chambers (100, 200) are typically located in two side-by-side but separate spaces.

## Description

Below are described reactors for epitaxial deposition of semiconductor material on substrates.

In particular, the semiconductor material to be deposited is silicon carbide, but other materials are not to be ruled out.

The substrates to be deposited upon are typically also made of silicon carbide, but other materials are not to be ruled out.

Reactors for epitaxial deposition of silicon carbide are long known.

In order to increase the throughput of a reactor, it is generally known to equip the reactor with at least two reaction chambers.

The advantage of an (at least) two-chamber reactor, rather than two single-chamber reactors, is the possibility of not duplicating each reactor component, i.e. using some components for both chambers. This also reduces the reactor footprint; this means the footprint of a dual chamber reactor is smaller than the sum of the footprints of two single chamber reactors.

From a design point of view, one can start, conceptually, from the design of a single chamber reactor and study how to integrate the two (or more) reactors.

Therefore, it is desirable to integrate the reactors as well as possible.

In particular, it is desirable that the reaction chambers are able be maintained separately and independently of each other, i.e. that while performing maintenance on one of the chambers, another of the chambers can be operational, used to perform epitaxial deposition processes.

Some examples of innovative multiple chamber reactors include: a first reaction chamber, a second reaction chamber, an induction heating system for said first and second reaction chambers, and a liquid cooling system for said first and second reaction chambers; said cooling system comprises a reservoir to contain and recirculate cooling liquid; said reservoir comprises a first reservoir section and a second reservoir section, in fluidic communication with each other
Other examples of innovative multiple chamber reactor designs include: a first reaction chamber running along a first longitudinal direction, a second reaction chamber running along a second longitudinal direction, an induction heating system for said first and second reaction chambers, and a liquid cooling system for said first and second reaction chambers; said first longitudinal direction and said second longitudinal direction are parallel; said first reaction chamber and said second reaction chamber are located in two spaces, side by side, but separated at least by a metal plate; said metal plate is configured to isolate the reaction chambers from each other mechanically and/or fluidically and/or magnetically.

Examples of innovative multiple chamber reactor designs will be clearer from the detailed description below, to be considered in conjunction with the following accompanying drawings:
Fig. 1 schematically shows some aspects of an example of an innovative dual chamber reactor design,
   and
Fig. 2 shows schematically (and from above) other aspects of an example of an innovative dual chamber reactor design.

As is easily understood, there are various ways of practically designing innovative multiple chamber reactor, and they are defined in their main advantageous aspects in the appended claims and are not limited either by the detailed description below or the appended drawings.

It should also be noted that the technical characteristics illustrated below in relation to specific examples of implementation are not to be considered closely linked to each other and are therefore not to be considered mutually binding, even if they are advantageously combinable.

### DETAILED DESCRIPTION

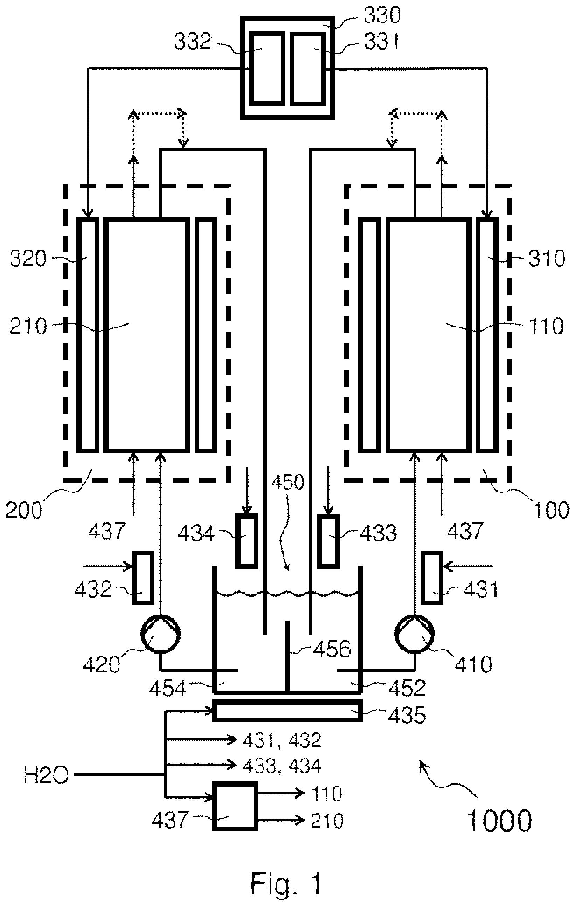

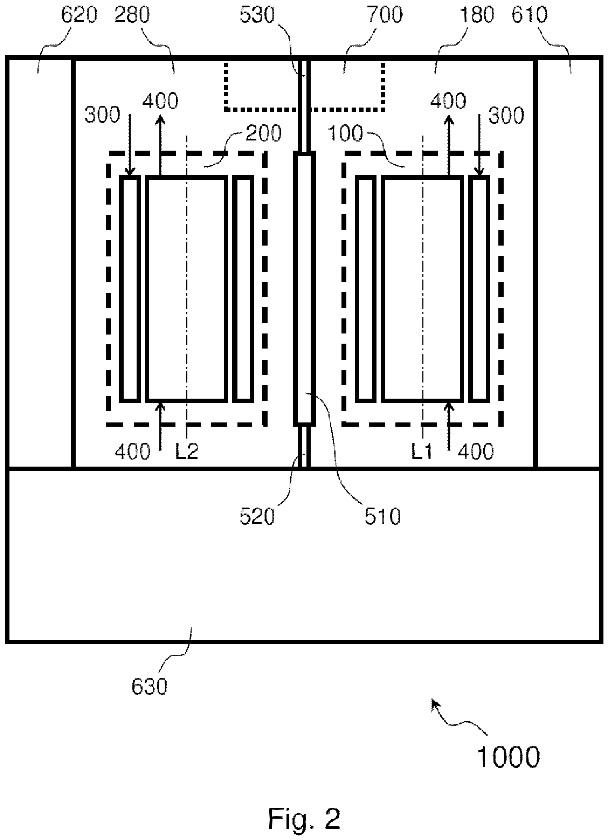

Fig. 1 and Fig. 2 schematically show different aspects of the same example of reactor design 1000 for epitaxial deposition of semiconductor material on substrates.

Reactor 1000 comprises a first reaction chamber 100 and a second reaction chamber 200. According to other design examples, the number of reaction chambers may be greater than two.

Furthermore, reactor 1000 comprises a chamber heating system and a chamber cooling system. The heating system typically comprises distinct and/or independent components for each of the chambers. The cooling system typically comprises distinct and/or independent components for each of the chambers, but also typically at least one common reservoir.

In Fig. 2, the heating system is schematically indicated with 300. Fig. 1 schematically shows some possible components of the heating system 300, in particular (at least) one inductor 310 that is associated with or forms part of the first chamber and (at least) one inductor 320 that is associated with or forms part of the second chamber 200, as well as a power system 330 that powers the inductors 310 and 320. Induction heating for epitaxial reactor reaction chambers (in particular, for hot-walled chambers used to deposit silicon carbide) is in itself known and, therefore, further details are avoided here.

In Fig. 2, the cooling system is shown schematically with reference 400. Fig. 1 shows, again schematically, some possible components of the cooling system 400, which will be specifically described below. Fig. 2 was intended to schematize a flow of coolant, specifically water, which first enters a hollow-walled (typically quartz) tube (element 110 of chamber 100 and element 210 of chamber 200), then flows along the tube, and finally exits the tube. Typically, the cooling system 400 is designed to recirculate the coolant, as shown in Fig. 2.

With reference to Fig. 1, reactor 1000 includes:
- a first reaction chamber 100,
- a second reaction chamber 200,
- an induction heating system (e.g., the set of components 310, 320 and 330) for the first reaction chamber 100 and the second reaction chamber 200, and
- a liquid cooling system for the first reaction chamber 100 and the second reaction chamber 200.

This heating system comprises a power system 330 that is typically comprised of a first power supply 331 for heating the first reaction chamber 100 and a second power supply 332 for heating the second reaction chamber 200.

This cooling system comprises a reservoir 450 designed to contain and to recirculate cooling liquid. The reservoir 450 comprises a first reservoir section 452 and a second reservoir section 454; the first reservoir section 452 and the second reservoir section 454 are in fluidic communication with each other. In the example of Fig. 1, the bottom of the first reservoir section 452 and the bottom of the second reservoir section 454 are flat and aligned; therefore, the bottom of the reservoir 450 is flat.

The first reservoir section 452 and the second reservoir section 454 may be in fluidic communication through a conduit and/or valve and/or wall. In the example of Fig. 1, such fluidic communication occurs through a wall 456 of predetermined height.

Advantageously, the first reservoir section 452 and the second reservoir section 454 are in fluidic communication at a predetermined level, in particular with respect to a bottom level of said reservoir 450; as shown in Fig. 1 such predetermined level corresponds to the height of the wall 456 with respect to the bottom of the reservoir 450 which, in this case, is flat and unique. This means that the reservoir 450 acts as a common reservoir for the chambers 100 and 200 if the liquid level is above that predetermined level. If for some reason, in particular a failure or rupture, the level of liquid in the reservoir 450 were to drop below this predetermined level, each of the reservoir sections would be independent of the other and could allow independent liquid recirculation cooling, in particular, the first section 452 for the first chamber 100 and the second section 454 for the second chamber 200, respectively.

In the example reactor design shown in Fig. 1, the reaction chamber 100 and the reaction chamber 200 comprise a hollow wall tube 110 and a hollow wall tube 210, respectively; the cavity of these tubes provides an annular conduit extending in the same longitudinal direction as the tube and along its entire length or substantially its entire length. Each of the hollow walls of the tubes is to be cooled by cooling fluid flowing along the cavity. The cooling system is configured to flow coolant, particularly water, first from the reservoir 450 to the tube 110 and to the tube 210, and then from the tube 110 and from the tube 210 back to the reservoir 450. In the example of Fig. 1, the coolant enters the hollow wall tube on one side and exits the opposite side; along this path it extracts heat and then heats up; if the inlet temperature is for example 20°C the outlet temperature can be for example 30-40°C.

In the reactor example shown in Fig. 1, the circulation of the cooling fluid is obtained by pump. In particular, the cooling system comprises a first pump 410 and a second pump 420; the first pump 410 is in fluidic communication with the first reservoir section 452 and the second pump 420 is in fluidic communication with the second reservoir section 454. Preferably, the first pump 410 and the second pump 420 draw coolant from the bottom of the first reservoir section 452 and the second reservoir section 454 respectively and direct coolant to the reaction chambers, in particular the chamber tubes.

In Fig. 1, schematically shown are return ducts that drop from above directly into the reservoir sections and carry coolant from the reaction chambers, in particular from the chamber tubes, into the reservoir. However, alternative configurations of such return conduits are foreseeable.

Advantageously, the cooling system comprises a liquid cooler; depending on how it is constructed, such liquid cooler comprises several components. The purpose of such a liquid cooler is to reduce the temperature of the coolant exiting the reaction chambers, in particular from the chamber tubes. In fact, as has been said, the coolant heats up as it flows into the reaction chambers and removes heat from the reaction chambers, and so it is advantageous for it to be forcibly cooled before entering the reaction chambers again, in particular the tubes of the chambers.

According to a first design, the liquid cooler comprises a first heat exchanger 431 configured to cool cooling liquid directed to the first tube 110 through a flow of water from outside the reactor 1000; this flow is schematized in Fig. 1 with the line associated with the written indication "H2O" (bottom of Fig. 1). The heat exchanger 431 of Fig. 1 has been schematized as an element in contact with a conduit exiting the first pump 410. In this case, the coolant is cooled by the heat exchanger after it has exited the reservoir 450, in particular the first reservoir section 452.

According to a second design, the liquid cooler comprises a second heat exchanger 432 configured to cool cooling liquid directed to the second tube 210 through a flow of water from outside the reactor 1000; such flow is schematized in Fig. 1 with the line associated with the written indication "H2O" (bottom of Fig. 1). The heat exchanger 432 of Fig. 1 has been schematized as an element in contact with a conduit exiting the second pump 420. In this case, the coolant is cooled by the heat exchanger after it has exited the reservoir 450, in particular the second reservoir section 454.

According to a third design, the liquid cooler comprises a third heat exchanger 435 configured to cool cooling liquid present in the reservoir 450 through a flow of water from outside of reactor 1000; such flow is schematically in Fig. 1 with the line associated with the written indication "H2O" (bottom of Fig. 1). The heat exchanger 435 of Fig. 1 is intended to cool both the coolant present in the reservoir section 452 and in the reservoir section 454. The heat exchanger 435 of Fig. 1 has been schematized as an element in contact with the bottom of the reservoir 450, in particular both the bottom of the reservoir section 452 and the bottom of the reservoir section 454; additionally or alternatively, the heat exchanger may be in contact with the side walls of the reservoir 450, in particular the reservoir section 452 and/or the reservoir section 454. Alternatively, for example, the heat exchanger may consist of one or more coiled conduits inside the reservoir 450, in particular to the reservoir section 452 and/or the reservoir section 454, intended to facilitate the flow of water from outside the reactor.

According to a fourth design, the liquid cooler comprises a fourth heat exchanger 431 configured to cool cooling liquid from the first tube 110 through a flow of water from outside of the reactor 1000; such flow is schematized in Fig. 1 with the line associated with the writing H2O (bottom of Fig. 1). The heat exchanger 431 of Fig. 1 has been schematized as an element in contact with a conduit exiting the tube 110. In this case, the coolant is cooled by the heat exchanger before returning to the reservoir 450, particularly in the first reservoir section 452.

According to a fifth embodiment, the liquid cooler comprises a fifth heat exchanger 432 configured to cool cooling liquid from the second tube 210 through a flow of water from outside of reactor 1000; such flow is schematically in Fig. 1 with the line associated with the writing H2O (bottom of Fig. 1). The heat exchanger 432 of Fig. 1 has been schematized as an element in contact with a conduit exiting the tube 210. In this case, the coolant is cooled by the heat exchanger before returning to the reservoir 450, particularly in the second reservoir section 454,

typically, if there is exchanger 431 and exchanger 432.

Among the various possibilities, it can be expected, for example, that there will be: A) exchanger 435 only or B) exchangers 431 and 432 only or C) exchangers 431 and 432 and 435 or D) exchangers 433 and 434 only or E) exchangers 433 and 434 and 435 or F) all exchangers 431 and 432 and 433 and 434 and 435.

The above refers to the cooling of the chambers, in particular the chamber tubes, in normal operating conditions.

Such a cooling system is advantageous because the coolant content is known and/or controlled/controllable, because the coolant temperature (at various points in the circuit) can be known and/or controlled/controllable, because the coolant flow (pressure and/or speed) (at various points in the circuit) can be known and/or controlled/controllable.

Such a cooling system is also advantageous because it is, at least in part, "redundant" thanks to the division of the tank into (partially) independent sections. Furthermore, since it is, in particular, an open circuit, it allows the tube, typically quartz, of the reaction chamber to be safeguarded by maintaining an adequate pressure, i.e. low and controlled.

However, it is advantageous to require cooling of the chambers even in case of failure and/or malfunction of the cooling system as described above, i.e. a cooling system based on coolant contained in a tank and in particular recirculated for example through one or more pumps.

It should be noted, in fact, that the temperature inside the reaction chamber [can] reach very high values (at least 1000°C, but also 1600° and above, in the case of epitaxial deposition of silicon carbide at pressures e.g., between 0.1 and 1.0 atm) and that flammable (e.g., hydrogen and/or methane) and/or toxic (e.g., silane) gases may flow into the reaction chamber.

For this purpose, the cooling system may advantageously comprise other components.

Essentially, if the cooling system is subject to failure (e.g., pump 410 or pump 420 malfunctions or there is a rupture in the reservoir section 452 or reservoir section 454 or there is a rupture in the tube 110 or tube 210) or malfunction (e.g., pump 410 and/or pump 420 malfunctions), cooling of the chamber or chambers may advantageously be carried out in another way. In this context, "breakage" (e.g., tank or tank section or pipe) is defined as an event that results in a fluid leak (even if only small); for example, the leak could be at a hydraulic junction.

For example, the cooling system may be configured to flow cooling water taken from a stream of water from the outside of reactor 1000 (this flow is schematized in Fig. 1 with the line associated with written indication "H2O") into tube 110 and/or tube 210. This should typically only occur under pre-determined conditions, particularly in the event of failure or malfunction. This supply of water flow can be carried out selectively through valves (not shown in Fig. 1) controlled manually and/or electrically; for example, the control of these valves could be carried out for example by an electronic control system (not shown in Fig. 1). In Fig. 1, the ability to send H2O water (directly) to chambers 100 and 200 is represented by the two horizontal arrows exiting block 437 (bottom of Fig. 1) and the vertical arrows entering chambers 110 and 210 coming from block 437; note that block 437 is not strictly necessary and will be illustrated below.

In this case, the cooling system is typically configured to drain cooling water from the tube 110 and/or the tube 210. This outflow may be directed towards the reservoir 450, as shown in Fig. 1. Alternatively, this outflow can be directed into a special drain precisely because the cooling water comes from outside reactor 1000. This outflow can be carried out selectively through valves (not shown in Fig. 1) controlled manually and/or electrically; for example, the control of these valves could be carried out for example by an electronic control system (not shown in Fig. 1). In Fig. 1, the ability to drain water (directly) from chambers 100 and 200 is represented by the vertical arrows at the top exiting the chambers.

It should be noted that in Fig. 1 the inlets in the water and coolant pipes are shown (particularly in the figure below) separated, but alternatively, they could take place through the same conduit.

It should be noted that in Fig. 1 the outlets from the water and coolant pipes are shown (particularly in the figure below) separated, but alternatively, they could take place through the same conduit.

The cooling system can be configured to process water from outside the reactor before flowing it into the tubes of the reactor chambers. For example, the processing may be physical filtering.

The cooling system can be configured to reduce water pressure from outside the reactor before flowing it into the reactor chamber tubes. Since the chamber tubes are fragile, it could be decided to send relatively low pressure water (for example, 0.2-1.7 bar, such as 1.5 bar) while water received from the outside may be relatively high pressure (for example, 3-6 bar, such as 4 bar).

In Fig. 1, the block 437 is designed to provide, for example, both water processing (for example water treatment, such as water filtering) and water pressure reduction.

With reference to Fig. 2, reactor 1000 includes (as partly already shown with reference to Fig. 1):
- a first reaction chamber 100 running along a first longitudinal direction L1,
- a second reaction chamber 200 running along a second longitudinal direction L2,
- an induction heating system 300 for the first reaction chamber 100 and the second reaction chamber 200,
   and
- a liquid flow cooling system 400 for the first reaction chamber 100 and the second reaction chamber 200;
the first longitudinal direction L1 and the second longitudinal direction L2 are parallel.

The first reaction chamber 100 and the second reaction chamber 200 are located in two spaces 180 and 280, side by side but separate.

The separation is made by one or more (typically metal) plates and/or one or more (typically metal) panels.

This separation is used to isolate reaction chambers from each other mechanically and/or fluidically and/or magnetically.

**In** particular, a metal plate 510 is required, at least in correspondence to the reaction chambers 100 and 200; this metal plate 510 is configured to isolate the reaction chambers from each other at least magnetically.

The possibility of magnetic isolation is linked to the fact that the heating system 300 is induction (magnetic) and therefore requires at least one inductor associated with each of the chambers. As can be seen from the figures, the inductors are typically solenoid, surrounding the chamber tubes and oriented along the longitudinal direction of tube development.

**In** order to achieve good magnetic insulation, the material of the metal plate 510 is preferably of high magnetic permeability.

**In** order to achieve good magnetic insulation, the material of the metal plate 510 is preferably aluminum or permalloy, more preferably aluminum.

In order to achieve good magnetic insulation, the metal plate 510 is preferably full and preferably 5-10 mm thick.

As seen in Fig. 2, the separation between the two gaps 180 and 280 can require both the metal plate 510 for magnetic isolation, and one or more metal panels 520 and 530 for mechanical and/or fluidic insulation. As seen in Fig. 2, the plate is situated in such a way as to insulate magnetically, but also mechanically and fluidly. As seen in Fig. 2, the panels are situated in such a way as to insulate mechanically and fluidly.

The possibility of mechanical isolation is linked to the creation of two separate spaces, also for maintenance purposes and not only for the operation of the chambers.

The possibility of fluidic isolation is linked to the possibility of (unwanted) gas leaking from the chambers; such leaks could also result in explosions.

For clarity (because it may not be evident from Fig. 2), please note that the plate 510 is located centrally (with respect to the reactor support plane), at least a first panel (in particular panel 520) is located below (with respect to the reactor support plane) and at least a second panel (in particular panel 530) is located above (with respect to the reactor support plane).

Both the plate and any panels are preferably full; however, it is possible that they can provide (small) openings for cable and/or conduit routing.

In Fig. 2, schematically shown is a system 700 for managing the exhaust gases that exit the reaction chambers - this figure shows the walls of its casing which is, for example, box-shaped.. Only one system is noted for all reaction chambers. In this design, the system is located in part in the area of the first reaction chamber 100 and in part in the area of the second reaction chamber 200. The enclosure of the implant 700 also contributes to the separation of the two spaces 180 and 280.

In reactor 1000 shown in Fig. 2, other spaces in addition to spaces 180 and 280 housing the reaction chambers 100 and 200 can be seen, in particular "maintenance spaces" (610, 620 and 630), i.e. spaces where personnel can perform maintenance operations on the reactor, in particular on the reactor's reaction chambers.

Typically, openable panels are provided for access to maintenance spaces; some of the panels could/should be alarmed; others of the panels may be freely openable.

Due to the wall 510 and/or the panels 520 and 530, safe maintenance operations can be performed on one of the reaction chambers while the other reaction chamber is fully operational.

There is preferably at least one maintenance space, i.e. there is at least one space in addition to the spaces for the reaction chambers.

In general, in an innovative reactor:
- a first maintenance space 610 is located on a first side of the reactor and adjacent to the space 180 of the first reaction chamber 100,
   and/or
- a second maintenance space 620 is located on a second side of the reactor and adjacent to the space 280 of the second reaction chamber 200,
   and/or
- a third maintenance space 630 is located at a front or back of the reactor and adjacent to both the spaces 180 and 280 of the reaction chambers 100 and 200.

The space 630 is useful, for example, for performing maintenance operations on a reaction chamber 100 or 200 (particularly on its gas inlet assembly) when it is retracted, for example thanks to a special slide on which the reaction chamber can rest, and moves into the space 630. **In** case the first and/or second maintenance spaces (610, 620) are used, the third maintenance space may be adjacent to spaces 180 and 610, and/or 280 and 620, as applicable.

The space 610 is useful, for example, for performing maintenance operations on the reaction chamber 100, in particular on its gas discharge assembly (not shown in Fig. 2), which may be called "discharge cylinder", which is axially aligned with the reaction chamber near the system 700, which may be cylindrical in shape.

The space 620 is useful, for example, for performing maintenance operations on the reaction chamber 200, in particular on its gas discharge assembly (not shown in Fig. 2), which may be called "discharge cylinder", which is axially aligned with the reaction chamber near the system 700, which may be cylindrical in shape.

It is clear that reactor 1000 may advantageously comprise both the components shown in Fig. 1 and the components shown in Fig. 2, and may include others.

The reactor 1000 may be protected by an outer shell, which may be continuous or partially interrupted, and composed of one or more outer panels. The one or more outer panels may enclose the reactor laterally, so as to provide the lateral portion of the outer shell. The one or more outer panels may also enclose the top and bottom portions of the reactor when it is standing for operation. so as to provide the top and bottom portions of the outer shell.

The top portion of the outer shell of the reactor may advantageously comprise at least two panels adapted to swing open in case of overpressure of the reactor (or explosion). For example, the at least two panels may be hinged and adapted to open and provide a safety vent when the pressure inside the reactor exceeds a predefined value.

## Claims

1. A reactor (1000) for epitaxial deposition of semiconductor material on substrates,
wherein the reactor comprises:
a first reaction chamber (100),
a second reaction chamber (200),
an induction heating system for said first reaction chamber (100) and said second reaction chamber (200), and
a liquid flow cooling system for said first reaction chamber (100) and said second reaction chamber (200);
wherein said cooling system comprises a reservoir (450) designed to contain and recirculate cooling liquid,
wherein said reservoir (450) comprises a first reservoir section (452) and a second reservoir section (454),
wherein said first reservoir section (452) and said second reservoir section (454) are in fluidic communication.

2. The reactor (1000) of claim 1, wherein said first reservoir section (452) and said second reservoir section (454) are in fluidic communication through a conduit and/or valve and/or wall (456), in particular a wall of predetermined height.

3. The reactor (1000) of claim 1 or 2, wherein said first tank section (452) and said second tank section (454) are in fluidic communication at a predetermined level with respect to a bottom level of said tank (450).

4. The reactor (1000) of claim 1 or 2 or 3, wherein said first reaction chamber (100) comprises a first hollow wall tube (110), said hollow wall being designed to be cooled by flowing cooling fluid, wherein said second reaction chamber (200) comprises a second hollow wall tube (210), said hollow wall being designed to be cooled by flowing cooling fluid, wherein said cooling system is configured to flow coolant first from said reservoir (450) into said first tube (110) and said second tube (210) and then from said first tube (110) and said second tube (210) into said reservoir (450).

5. The reactor (1000) of claim 4, wherein said cooling system comprises a first pump (410) and a second pump (420), said first pump (410) being in fluidic communication with said first reservoir section (452) in particular at a bottom of said first reservoir section (452), said second pump (420) being in fluidic communication with said second reservoir section (454) in particular at a bottom of said second reservoir section (454).

6. The reactor (1000) of claim 4 or 5, wherein said cooling system comprises a liquid cooler (431, 432, 433, 434, 435).

7. The reactor (1000) of claim 6, wherein said liquid cooler comprises a heat exchanger (435) configured to cool the cooling liquid present in said reservoir (450) through a flow of water from outside the reactor (1000).

8. The reactor (1000) of claim 6 or 7, wherein said liquid cooler comprises a first heat exchanger (431) configured to cool the cooling liquid directed to said first tube (110) and/or a second heat exchanger (432) configured to cool the cooling liquid directed to said second tube (210) through a flow of water from outside the reactor (1000).

9. The reactor (1000) of claim 6 or 7 or 8, wherein said liquid cooler comprises a first heat exchanger (433) configured to cool the cooling liquid from said first tube (110) and/or a second heat exchanger (434) configured to cool the cooling liquid from said second tube (210) through a flow of water from outside the reactor (1000).

10. The reactor (1000) of any one of the preceding claims, wherein said cooling system is configured to flow cooling water taken from a stream of water from outside the reactor (1000) into said first tube (110) and/or said second tube (210) under predetermined conditions, particularly in case of failure or malfunction.

11. The reactor (1000) of claim 10, wherein said cooling system is configured to treat (437) water from outside the reactor (1000) before flowing it into said first tube (110) and/or said second tube (210).

12. The reactor (1000) of claim 10 or 11, wherein said cooling system is configured to reduce pressure (437) of water from outside the reactor (1000) before flowing it into said first tube (110) and/or said second tube (210).

13. The reactor (1000) of claim 10 or 11 or 12, wherein said cooling system is configured to flow cooling water from said first tube (110) and/or said second tube (210) into said tank (450).

14. The reactor (1000) of claim 10 or 11 or 12, wherein said cooling system is configured to drain cooling water from said first tube (110) and/or said second tube (210) into a discharge when coming from outside the reactor (1000).

15. A reactor (1000) for epitaxial deposition of semiconductor material on substrates,
wherein the reactor comprises:
a first reaction chamber (100) running along a first longitudinal direction (L1),
a second reaction chamber (200) running along a second longitudinal direction (L2),
an induction heating system (300) for said first reaction chamber (100) and said second reaction chamber (200), and
a liquid flow cooling system (400) for said first reaction chamber (100) and said second reaction chamber (200);
wherein said first longitudinal direction (L1) and said second longitudinal direction (L2) are parallel,
wherein said first reaction chamber (100) and said second reaction chamber (200) are located in two spaces (180, 280) side by side but separated by a metal plate (510) at least in correspondence to the reaction chambers (100, 200), said metal plate (510) being configured to isolate the reaction chambers (100, 200) from each other at least magnetically.

16. The reactor (1000) of claim 15, wherein said metal plate (510) is made of high magnetic permeability material.

17. The reactor (1000) of claim 15 or 16, wherein said metal plate (510) is made of aluminum or permalloy, preferably aluminum.

18. The reactor (1000) of claim 15 or 16 or 17, wherein said metal plate (510) is full and preferably has a thickness of 5-10 mm.

19. The reactor (1000) of any claim 15 to 18, said metal plate (510) and one or more metal panels (520, 530) are located so as to mechanically and/or fluidly isolate said two spaces (180, 280) from each other.

20. The reactor (1000) of claim 19, wherein said metal plate (510) is located centrally, wherein at least a first panel (520) is located below and/or at least a second panel (530) is located above.

21. The reactor (1000) of any claim 15 to 20, further comprising at least one maintenance space (610, 620, 630).

22. The reactor (1000) of claim 21, wherein a first maintenance space (610) is situated in correspondence with a first side of the reactor and adjacent to the space (180) of the first reaction chamber (100),
and/or
wherein a second maintenance space (620) is located in correspondence with a second side of the reactor and adjacent to the space (280) of the second reaction chamber (200),
and/or
wherein a third maintenance space (630) is located at a front or back of the reactor and adjacent to both spaces (180, 280) of the reaction chambers (100, 200).
